# FASCICULE DE BREVET EUROPEEN

(11) **EP 1 518 005 B1**
(45) Date de publication et mention de la délivrance du brevet: **14.11.2007**
(21) Numéro de dépôt: 03760059.0
(22) Date de dépôt: 18.06.2003
(51) Int. Cl.: C23C 14/24, C30B 23/02

(54) **CHAMBRE D EVAPORATION DE MATERIAUX SOUS VIDE A POMPAGE DIFFENRENTIEL**
MATERIALVERDAMPFUNGSKAMMER MIT DIFFERENTIALVAKUUMPUMPE
MATERIAL EVAPORATION CHAMBER WITH DIFFERENTIAL VACUUM PUMPING

(30) Priorité: 18.06.2002 FR 0207501
(43) Date de publication de la demande: 30.03.2005
(73) Titulaire: RIBER, F-92500 Rueil-Malmaison (FR)
(72) Inventeur: CHAIX, Catherine, F-78170 La Celle-Saint-Cloud (FR); JARRY, Alain Bâtiment C, F-78300 Poissy (FR); NUTTE, Pierre-André, F-75017 Paris (FR); LOCQUET, Jean-Pierre, Bern (CH); FOMPEYRINE, Jean, CH-8820 Waedenswil (CH); SIEGWART, Heinz, CH-8047 Zürich (CH)
(74) Mandataire: Michelet, Alain
(86) Numéro de dépôt international: PCT/FR2003/001868
(87) Numéro de publication internationale: WO 2003/106731

(56) Documents cités:
- EP-A- 0 276 914
- EP-A- 0 302 506
- EP-A- 0 655 514
- WO-A-01/55472
- US-A- 5 556 472
- US-A- 5 951 767

## Description

La présente invention concerne une chambre d'évaporation de matériaux sous vide.

L'état de propreté d'une surface ou de pureté d'un film déposé sont primordiales dans des domaines techniques tels que les nanotechnologies, la chimie catalytique, les biotechnologies.

Dans les nanotechnologies, par exemple, dont le champ d'application porte sur des objets de l'ordre de quelques nanomètres à quelques micromètres, la compréhension de phénomènes tels que la croissance de films, les réactions photoinduites dans lesdits films ne peut se faire que si les films et, les substrats sur lesquels ils sont formés, sont vierges de toute contamination.

Dans le domaine des semi-conducteurs, la croissance de films présentant peu d'impuretés, et donc peu de dopants non intentionnels, est également essentielle. Le dépôt de matériaux purs en quantité connue sur des surfaces semi-conductrices est, en effet, particulièrement important pour la réalisation de jonctions métal-semi-conducteurs et hétérostructures semi-conductrices. Les premières se retrouvent dans tous les contacts métalliques des dispositifs semi-conducteurs, par exemple, les contacts ohmiques de détecteur électronique. Les secondes sont importantes pour les dispositifs optoélectroniques.

Enfin, les hétérostructures métalliques connaissent également un intérêt marqué de part leurs applications possibles dans des domaines tels que le magnétisme.

Une des techniques courantes pour préparer de telles structures sous ultravide est l'Epitaxie par Jet Moléculaire ("MBE"-Molecular Beam Epitaxy). Avec cette technique, des couches épitaxiales sont obtenues par le transport du matériau, contenant les éléments constitutifs de la couche à former, jusqu'à un substrat, métallique ou semi-conducteur, où il s'adsorbe. L'Epitaxie par Jet Moléculaire permet d'obtenir, en particulier pour les semi-conducteurs, une croissance de couches contrôlées en dopage et dont la composition chimique peut être variée en profondeur sur l'espace de quelques angströms.

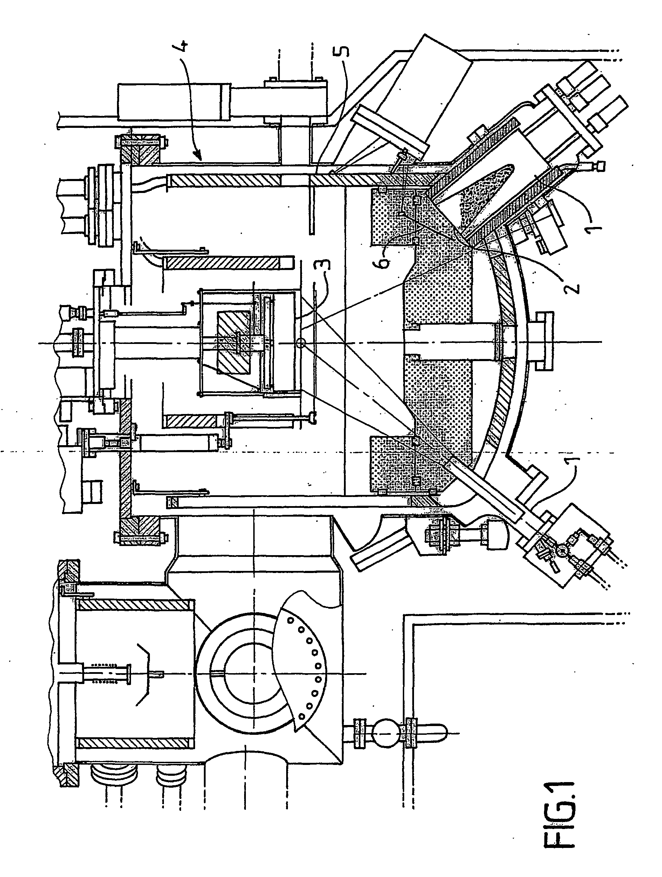

Une chambre d'évaporation comprend donc plusieurs sources de matériau 1 (Figure 1). Ces sources 1 sont utilisées alternativement en fonction de l'empilement de couches à former. Diverses sources de matériau 1 peuvent être envisagées, la plus courante étant l'évaporation à partir d'une cellule comportant un creuset chauffé par effet Joule. D'autres possibilités comprennent l'utilisation d'une source de plasma dont le gaz est, par exemple, de l'oxygène (O₂), de l'hydrogène (H₂), de l'azote (N₂) ou autres, ou des injecteurs à gaz ou encore des canons à évaporation par bombardement électronique. Lorsque ces sources 1 sont des cellules, leurs creusets ont généralement une forme cylindrique ou conique ou autre, ouverte à une extrémité 2 et sont montés de telle sorte que ladite ouverture 2 est placée en regard du substrat 3 sur lequel le dépôt de matériau doit être opéré.

Comme décrit précédemment, un des impératifs de ces systèmes de déposition est la faible contamination des films formés. Outre le dépôt de matériau dans une chambre 4 sous vide et de préférence sous ultravide, i.e. à une pression inférieure à 10⁻⁹ Torr (1 Torr = 133.3 Pa), les sources de matériau 1 ne doivent pas, elles-mêmes, être une source éventuelle de contamination. Elles sont donc l'objet d'un dégazage poussé.

Cependant, la présence de plusieurs sources 1 dans la chambre d'évaporation est à l'origine d'un autre type de contamination : une contamination croisée des sources de matériau 1. Cette contamination peut, en partie, être celle des sources solides par les gaz en présence (ionisé ou non). Lorsque l'une de ces sources 1 est utilisée par la suite, non seulement les éléments dudit creuset sont évaporés en direction du substrat 3 mais éventuellement aussi des éléments contaminateurs adsorbés ou ayant réagis avec ladite source. La couche ainsi déposée sur le substrat 3 contient alors des impuretés non intentionnelles qui peuvent influer en cas de matériau semi-conducteur non seulement sur son dopage mais également sur les propriétés du matériau. La présence de panneaux réservoirs 5 à circulation d'azote liquide placés au voisinage de ces sources 1 pour condenser les gaz et de caches individuels 6 placés devant les sources 1 non utilisées ne constitue pas une solution totalement satisfaisante pour éviter cette contamination croisée.

L'objectif de la présente invention est de proposer une chambre d'évaporation de matériaux sous vide, simple dans sa conception et dans son mode opératoire, comprenant des sources d'évaporation de matériau pour la croissance de couches sur un substrat qui soient protéger de tout type de contamination.

A cet effet, l'invention concerne une chambre d'évaporation de matériaux comprenant une chambre à vide, une première unité de pompage pour pomper ladite chambre et des sources de matériau. Selon l'invention,
- une paroi pouvant assurer une étanchéité totale ou partielle au vide, délimite au sein de la chambre à vide un premier volume pompé par ladite première unité de pompage et un deuxième volume pompé par une deuxième unité de pompage,
- certaines desdites sources de matériau ayant un axe principal sont placées dans le deuxième volume et d'autres sources sont placées dans le premier volume,
- ladite paroi comporte des évidements, chaque évidement étant centré sur l'axe principal d'une des sources de matériau ayant un axe principal,
   et
- la chambre comprend des moyens pour obturer ou dégager chacun desdits évidements, lesdits moyens étant contrôlés individuellement pour protéger les sources de matériau ayant un axe principal non utilisées.

La présente invention concerne également les caractéristiques qui ressortiront au cours de la description qui va suivre et qui devront être considérées isolément ou selon toutes leurs combinaisons techniquement possibles :
- les moyens pour obturer ou dégager lesdits évidements comprennent des caches,
- lors d'une croissance, le débit, à travers les évidements dégagés, des éléments constitutifs des matériaux venant du premier volume est pompé par la deuxième unité de pompage.

On entend par "croissance", le développement progressif de couches sur l'échantillon par l'adsorption des éléments constitutifs des matériaux évaporés par les sources placées dans la chambre d'évaporation. On distingue la croissance en coévaporation dans laquelle au moins une des sources de matériau placées dans le premier volume et au moins une des sources placées dans le deuxième volume sont mises en oeuvre simultanément et la croissance séquentielle où une seule des sources placées dans la chambre d'évaporation est en fonctionnement à la fois. Dans ce dernier cas, lors de l'opération d'une des sources placées dans le premier volume, les moyens pour obturer ou dégager chacun desdits évidements sont en position d'obturation.
- la paroi pouvant assurer une étanchéité totale ou partielle au vide comprend une plaque,
- la première unité de pompage comprend une pompe primaire et une pompe secondaire,
- la deuxième unité de pompage comprend une pompe secondaire,
- le premier volume et le deuxième volume comprennent au moins un panneau réservoir à azote liquide,
- le deuxième volume délimité par la paroi est à une pression inférieure à 10⁻⁷ Torr.
- la chambre d'évaporation comprend des moyens de contrôle de la pression pour mesurer indépendamment la pression dans le premier volume et le deuxième volume,
- les sources de matériau ayant un axe principal placées dans le deuxième volume comprennent des cellules à creusets chauffés par effet Joule,
- les sources de matériau ayant un axe principal placées dans le deuxième volume comprennent des canons à évaporation par bombardement électronique,
- les sources placées dans le premier volume comprennent au moins une source de plasma,
- les sources placées dans le premier volume comprennent au moins un injecteur à gaz.

L'invention sera décrite plus en détail en référence aux dessins annexés dans lesquels :
- la figure 1 est une représentation schématique d'une chambre d'évaporation de l'art antérieur,
- la figure 2 est une représentation schématique d'une chambre d'évaporation de matériaux, selon un mode de réalisation de l'invention;
- la figure 3 est une vue de dessus d'une paroi pouvant assurer une étanchéité totale ou partielle au vide, selon un mode de réalisation de l'invention;

La chambre d'évaporation de matériaux, selon l'invention, comprend une chambre à vide 10 comportant un échantillon 11 pouvant être monté sur un manipulateur 12. Cette chambre a pour objectif premier la croissance de couches par évaporation de matériaux purs et en quantité connue sur cet échantillon 11. II s'agit de tout type de matériau pouvant être usuellement évaporé sous vide (Aluminium (AI), Calcium (Ca), Indium (In), Lanthane (La), Lithium (Li), Gallium (Ga), Strontium (Sr), Titane (Ti), Yttrium (Y), Zirconium (Zr), ...). Ladite chambre 10 comporte de préférence des brides ou piquages de transfert permettant de relier celle-ci à d'autres chambres pour constituer un ensemble unique sous vide pour le traitement et la préparation d'un échantillon 11, voire l'analyse et la modification dudit échantillon 11 formé. Le transport dudit échantillon 11 d'une chambre à une autre est alors réalisé par des bras manipulateurs.

La chambre d'évaporation est pompée par une première unité de pompage 13. Cette première unité de pompage 13 comprend préférentiellement une pompe primaire et une pompe secondaire, par exemple, une pompe cryogénique ou une pompe turbomoléculaire, ou autre. En outre, ladite unité de pompage 13 peut comprendre un sublimateur de Titane 14 et un panneau cryogénique 15. La chambre 10 peut comprendre un panneau cryogénique général 16 permettant de maintenir la pureté des couches. La chambre comprend également des moyens de contrôle de la pression au sein de celle-ci. Ces moyens de contrôle comprennent, par exemple, des jauges dites BAYARD-ALPERT reliées à un dispositif externe de contrôle de la pression.

La chambre d'évaporation comprend des sources de matériau. Diverses sources de matériau peuvent être envisagées, la plus courante étant l'évaporation à partir d'une source 17 du type Knudsen. Il s'agit alors d'un creuset chauffé par effet Joule. Le creuset qui peut être réalisé en nitrure de Bore ou en graphite de haute pureté, par exemple, présente une forme cylindrique ou conique ou autre, ayant un axe principal 18. L'une des extrémités 19 dudit creuset est ouverte et placée en vis-à-vis du manipulateur 12. Cet effet Joule peut être obtenu par l'utilisation d'un élément résistant par exemple, un filament. Le filament est avantageusement réalisé en Tantale (Ta) mais peut également être réalisé en d'autres matériaux réfractaires (Molybdène (Mo), Tungstène (W), ....). Dans un autre mode de réalisation, l'évaporation est générée par le bombardement électronique d'un matériau source dans un canon d'évaporation 20.
La chambre d'évaporation comprend aussi d'autres sources de matériau 21 telles que des sources de plasma ou des injecteurs à gaz dont le produit est susceptible de réagir avec les matériaux des sources 17 ayant un axe principal 18. Cet axe principal 18 définit également un axe principal d'évaporation. Le gaz support du plasma ou le gaz de l'injecteur est alors choisi parmi l'oxygène (O₂), l'azote (N₂), l'hydrogéne (H₂), ... De préférence, l'échantillon 11 est également contrôlé en température, i.e. sa température peut être variée selon les éléments à déposer sur la surface dudit échantillon 11.

Selon l'invention, les sources de matériau 17 ayant un axe principal 18 sont placées dans un volume délimité 22 au sein de ladite chambre par une paroi 23. Cette paroi 23 peut assurer une étanchéité totale ou partielle au vide et le volume délimité 22 par la paroi 23 est pompé par une deuxième unité de pompage 24. Cette paroi 23 est dans un mode de réalisation réalisé en métal (Tantale, Molybdène, inox, ...). On distinguera donc un premier volume 25 contenant les sources 21 telles que sources à plasma ou injecteurs à gaz, ledit volume étant pompé par la première unité de pompage 13, et un deuxième volume 22 comprenant les sources de matériaux 17 ayant un axe principal 18 telles que des cellules à creuset, et des canons d'évaporation 20 par bombardement électronique.

Ladite paroi 23 comporte des évidements 26, chaque évidement 26 étant centré sur l'axe principal 18 d'une des sources de matériau 17 ayant un axe principal 18 placées dans le deuxième volume 22. Lorsque la source de matériau 17 correspondante à un évidement 26 est en fonctionnement, le jet moléculaire émis par cette source traverse dans son transport vers l'échantillon 11 ledit évidement 26. Afin de maintenir un vide poussé dans le deuxième volume 22 délimité par la paroi 23, i.e. une pression inférieure à 10⁻⁷ Torr et préférentiellement à 10⁻⁹ Torr, la chambre 10 comprend des moyens 27 pour obturer chacun desdits évidements 26. Ces moyens 27 sont contrôlés individuellement pour dégager l'évidement 26 d'une source de matériau 17 sélectionnée. Ces moyens 27 pour obturer chacun desdits évidements 26 sont dans un mode de réalisation des caches, par exemple, à basculement ou linéaires, ou autres. Ces moyens 27 permettent de protéger les sources de matériaux 17 d'éventuelles contaminations. Ces contaminations peuvent résulter, par exemple, de l'opération d'une des sources 21 (injecteur à gaz, source de plasma, ...) placées dans le premier volume 25. Avantageusement, la pression partielle p₁ mesurée dans le premier volume 25 lors d'un dépôt n'affecte sensiblement pas la pression p₂ mesurée dans le deuxième volume 22 pompé par la deuxième unité de pompage. En d'autres termes, lors d'une croissance, le débit des éléments constituants le plasma, par exemple, à travers les évidements 26 ouverts est inférieur à la vitesse de pompage S de la deuxième unité 24 de pompage et est donc pompé par celle-ci. Cependant, même si ledit débit est supérieur à la vitesse de pompage, le principe de pompage différentiel permet quand même la protection des sources de matériaux 17. En effet, la quantité des éléments constituants le plasma qui aura pénétré dans la partie basse de la chambre sera pompée par la deuxième unité de pompage 24, une fois les évidements 26 de la paroi 23 obturés par les caches 27 fermés. Le temps de présence des éléments constituants le plasma à proximité des sources de matériaux 17 ne sera donc que limité. La deuxième unité de pompage 24 comprend au moins une pompe secondaire telle qu'une pompe cryogénique, une pompe turbomoléculaire ou autre: Le deuxième volume 22 délimité par la paroi 23 peut aussi comporter au moins un panneau réservoir 28 à circulation d'Azote liquide. Ces surfaces de condensation supplémentaires permettent de limiter la présence d'impuretés dans le jet moléculaire et dans le deuxième volume 22. De préférence, la pression dans le deuxième volume 22 délimité par la paroi 23 est mesurée par des moyens de contrôle de la pression du type jauge dite BAYARD-ALPERT.

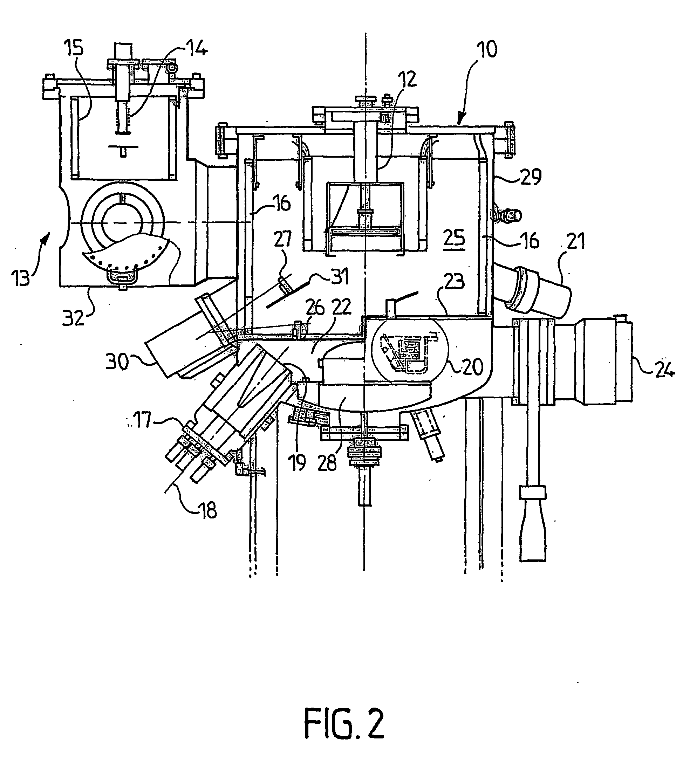

La figure 2 montre un mode de réalisation de l'invention. Le volume de la chambre d'évaporation est divisée en un premier volume 25 et un deuxième volume 22 par une paroi 23. Cette paroi 23 est une plaque en molybdène qui est fixée sur les murs latéraux 29 de l'enceinte 10 de façon à assurer une étanchéité totale ou partielle au vide. Elle est dans ce cas soudée ou fixée aux dits murs 29. Cette plaque 23 comporte des évidements 26 dont un seul est schématisé sur la figure 2 par simplification. Cet évidement 26 est centré sur l'axe principal 18 d'une source de matériau 17 placée dans le deuxième volume 22 délimité par la plaque 23, dans la partie basse de la chambre d'évaporation. Des moyens 27 permettent d'obturer et de dégager ledit évidement 26. Ces moyens 27 comprennent un cache à basculement activé par un dispositif externe de basculement 30. Chaque cache 27 est contrôlé individuellement. Lorsqu'un cache 27 est en position d'obturation, la lame 31 du cache est parallèle à la surface de la plaque 23 autour de l'évidement 26 considéré de manière à assurer un contact parfait entre ladite surface et le cache 27. Cette étanchéité est également renforcée par la différence de pression qui existe entre le premier volume 25 et le deuxième volume 22 lors de l'opération d'une des sources 21 telles qu'un source de plasma ou un injecteur à gaz, placées dans le premier volume 25.
Le premier volume 25 de la chambre d'évaporation est pompé par une première unité de pompage 13 constituée d'un puit de pompage 32 comprenant un panneau cryogénique 15 offrant ainsi une surface de condensation, une ou plusieurs pompes secondaires cryogéniques servant à la fois pour la descente en vide de la chambre et pour le pompage des éléments en présence lors de la croissance de couches, un sublimateur de Titane 14 pour assurer la descente en vide. Le deuxième volume 22 délimité par la plaque 23 est pour sa part pompé par une pompe turbo-moléculaire 24 et un panneau réservoir 28 à circulation d'Azote liquide pour le pompage des espèces en présence lors de la croissance de couches et lors de l'ouverture du cache 27 de la source sélectionnée correspondante.

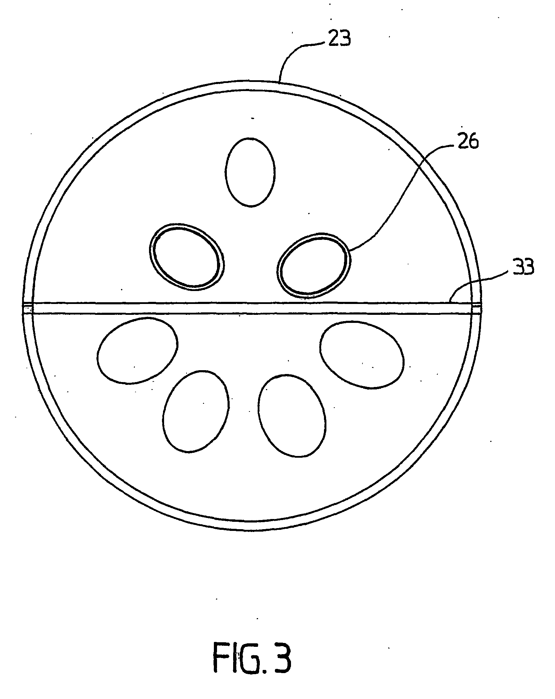

La figure 3 montre une vue de dessus de la plaque 23 décrite dans le mode de réalisation précédent et correspondant à la figure 2. Cette plaque 23 comporte des évidements 26 qui ont une forme elliptique. Cette forme elliptique résulte de la prise en considération de la forme tubulaire des sources de matériau 17 et de l'inclinaison de leur axe principal 18 par rapport à la plaque 23. Le double trait 33 schématise le décrochement de la plaque 23 en son milieu, apparent sur la figure 2.
Les sources de matériau 17 ayant un axe principal 18 placées dans le deuxième volume 22 délimité par la paroi 23 et les sources 21 telles qu'une source de plasma ou injecteur à gaz placées dans le premier volume 25 sont utilisées dans cette chambre d'évaporation pour obtenir la croissance de couches d'oxyde, de nitrure ou de semi-conducteurs.

## Revendications

1. Chambre d'évaporation de matériaux comprenant une chambre à vide (10), une première unité de pompage (13) pour pomper ladite chambre et des sources de matériau, **caractérisée en ce que** :
- une paroi (23) pouvant assurer une étanchéité totale ou partielle au vide, délimite au sein de la chambre à vide (10) un premier volume (25) pompé par ladite première unité de pompage (13) et un deuxième volume (22) pompé par une deuxième unité de pompage (24),
- certaines desdites sources de matériau (17) ayant un axe principal (18) sont placées dans le deuxième volume (22) et d'autres sources (21) sont placées dans le premier volume (25),
- ladite paroi (23) comporte des évidements (26), chaque évidement (26) étant centré sur l'axe principal (18) d'une des sources de matériau (17) ayant un axe principal (18),
et **en ce que**,
- la chambre comprend des moyens (27) pour obturer ou dégager chacun desdits évidements (26), lesdits moyens (27) étant contrôlés individuellement pour protéger les sources de matériau (17) ayant un axe principal d'évaporation (18) non utilisées.

2. Chambre d'évaporation selon la revendication 1, **caractérisée en ce que** les moyens (27) pour obturer ou dégager lesdits évidements (26) comprennent des caches.

3. Chambre d'évaporation selon la revendication 1 ou 2, **caractérisée en ce que** lors d'une croissance, le débit, à travers les évidements (26) dégagés, des éléments constitutifs des matériaux venant du premier volume (25) est pompé par la deuxième unité de pompage (24).

4. Chambre d'évaporation selon l'une quelconque des revendications 1 à 3, **caractérisée en ce que** la paroi (23) pouvant assurer une étanchéité totale ou partielle au vide comprend une plaque.

5. Chambre d'évaporation selon l'une des revendications 1 à 4, **caractérisée en ce que** la première unité de pompage (13) comprend une pompe primaire et une pompe secondaire.

6. Chambre d'évaporation selon l'une des revendications 1 à 5, **caractérisée en ce que** la deuxième unité de pompage (24) comprend une pompe secondaire.

7. Chambre d'évaporation selon les revendications 5 et 6, **caractérisée en ce que** le premier volume (25) et le deuxième volume (22) comprennent au moins un panneau réservoir (16, 28) à azote liquide.

8. Chambre d'évaporation selon l'une quelconque des revendications 1 à 7, **caractérisée en ce que** le deuxième volume (22) délimité par la paroi (23) est à une pression inférieure à 10⁻⁷ Torr.

9. Chambre d'évaporation selon l'une quelconque des revendications 1 à 8, **caractérisée en ce que** la chambre d'évaporation comprend des moyens de contrôle (16) de la pression pour mesurer indépendamment la pression dans le premier volume (25) et le deuxième volume (22).

10. Chambre d'évaporation selon l'une quelconque des revendications 1 à 9, **caractérisée en ce que** les sources de matériau (17) ayant un axe principal (18) placées dans le deuxième volume (22) comprennent des cellules à creusets chauffés par effet Joule.

11. Chambre d'évaporation selon l'une quelconque des revendications 1 à 10, **caractérisée en ce que** les sources de matériau (17) ayant un axe principal (18) placées dans le deuxième volume (22) comprennent des canons à évaporation (20) par bombardement électronique.

12. Chambre d'évaporation selon l'une quelconque des revendications 1 à 11, **caractérisée en ce que** les sources (21) placées dans le premier volume (25) comprennent au moins une source de plasma.

13. Chambre d'évaporation selon l'une quelconque des revendications 1 à 12, **caractérisée en ce que** les sources (21) placées dans le premier volume (25) comprennent au moins un injecteur à gaz.

## Claims

1. An evaporation chamber of materials comprising a vacuum chamber (10), a first pumping unit (13) to pump said chamber and sources of material, **characterised in that**:
- a wall (23) liable to provide total or partial vacuum tightness, delineates within the vacuum chamber (10) a first volume (25) pumped by said first pumping unit (13) and a second volume (22) pumped by a second pumping unit (24),
- some of said sources of material (17) having a main axis (18) are placed in the second volume (22) and other sources (21) are placed in the first volume (25),
- said wall (23) comprises recesses (26), each recess (26) being centred on the main axis (18) of one of the sources of material (17) having a main axis (18),
and **in that**,
- the chamber comprises means (27) for sealinging or clearing each of said recesses (26), said means (27) being controlled individually to protect the sources of material (17) having a main evaporation axis (18) unused.

2. An evaporation chamber according to claim 1, **characterised in that** the means (27) for sealing or clearing said recesses (26) comprise masks.

3. An evaporation chamber according to claim 1 or 2, **characterised in that** when growing, the flow rate, through the recesses (26) cleared, of the elements forming the materials from the first volume (25) is pumped by the second pumping unit (24).

4. An evaporation chamber according to any one of claims 1 to 3, **characterised in that** the wall (23) liable to provide total or partial vacuum tightness comprises a plate.

5. An evaporation chamber according to any one of claims 1 to 4, **characterised in that** the first pumping unit (13) comprises a primary pump and a secondary pump.

6. An evaporation chamber according to any one of claims 1 to 5, **characterised in that** the second pumping unit (24) comprises a secondary pump.

7. An evaporation chamber according to claims 5 and 6, **characterised in that** the first volume (25) and the second volume (22) comprise at least one liquid nitrogen storage panel (16, 28).

8. An evaporation chamber according to any one of claims 1 to 7, **characterised in that** the second volume (22) delineated by the wall (23) has a pressure lower than 10⁻⁷ Torr.

9. An evaporation chamber according to any one of claims 1 to 8, **characterised in that** the evaporation chamber comprises means (16) for controlling the pressure in order to measure independently the pressure in the first volume (25) and the second volume (22).

10. An evaporation chamber according to any one of claims 1 to 9, **characterised in that** the sources of material (17) having a main axis (18) placed in the second volume (22) comprise crucible cells heated by Joule effect.

11. An evaporation chamber according to any one of claims 1 to 10, **characterised in that** the sources of material (17) having a main axis (18) placed in the second volume (22) comprise electronic beam evaporation guns (20).

12. An evaporation chamber according to any one of claims 1 to 11, **characterised in that** the sources (21) placed in the first volume (25) comprise at least one source of plasma.

13. An evaporation chamber according to any one of claims 1 to 12, **characterised in that** the sources (21) placed in the first volume (25) comprise at least one gas injector.

## Patentansprüche

1. Materialverdampfungskammer, die eine Vakuumkammer (10), eine erste Pumpeinheit (13) zum Abpumpen der Kammer und Materialquellen aufweist, **dadurch kennzeichnet:**
- **dass** eine Wand (23), die eine komplette oder teilweise Vakuumabdichtung sicherstellen kann, innerhalb der Vakuumkammer (10) ein erstes Volumen (25) abgrenzt, das von der ersten Pumpeinheit (13) abgepumpt wird, und ein zweites Volumen (22), das von einer zweiten Pumpeinheit (24) abgepumpt wird,
- **dass** bestimmte Materialquellen (17), die eine Hauptachse (18) haben, in dem zweiten Volumen (22) angeordnet sind, und dass weitere Quellen (21) in dem ersten Volumen (25) angeordnet sind,
- **dass** die Wand (23) Aussparungen (26) aufweist, wobei jede Aussparung (26) auf die Hauptachse (18) eine der Materialquellen (17), die eine Hauptachse (18) hat, zentriert ist,
und **dass**
- die Kammer Mittel (27) aufweist, um jede der Aussparungen (26) zu verschließen oder freizugeben, wobei die Mittel (27) einzeln gesteuert werden, um die Materialquellen (17), die eine Hauptverdampfungsachse (18) haben, die nicht verwendet werden, zu schützen.

2. Materialverdampfungskammer nach Anspruch 1, **dadurch gekennzeichnet, dass** die Mittel (27) zum Verschließen oder Freigeben der Aussparungen (26) Abdeckungen aufweisen.

3. Verdampfungskammer nach Anspruch 1 oder 2, **dadurch gekennzeichnet, dass** bei einem Wachstum der Durchsatz durch die freigegebenen Aussparungen (26) der Bestandteile der Materialien, die von dem ersten Volumen (25) kommen, von der zweiten Pumpeinheit (24) abgepumpt wird.

4. Verdampfungskammer nach einem der Ansprüche 1 bis 3, **dadurch gekennzeichnet, dass** die Wand (23), die eine komplette oder teilweise Vakuumabdichtung sicherstellen kann, eine Platte aufweist.

5. Verdampfungskammer nach einem der Ansprüche 1 bis 4, **dadurch gekennzeichnet, dass** die erste Pumpeinheit (13) eine Hauptpumpe und eine Hilfspumpe aufweist.

6. Verdampfungskammer nach einem der Ansprüche 1 bis 5, **dadurch gekennzeichnet, dass** die zweite Pumpeinheit (24) eine Hilfspumpe aufweist.

7. Verdampfungskammer nach den Ansprüchen 5 und 6, **dadurch gekennzeichnet, dass** das erste Volumen (25) und das zweite Volumen (22) eine Behältertafel (16, 28) mit flüssigem Stickstoff aufweisen.

8. Verdampfungskammer nach einem der Ansprüche 1 bis 7, **dadurch gekennzeichnet, dass** das zweite Volumen (22), das von der Wand (23) abgegrenzt ist, einen Druck unter 10⁻⁷ Torr hat.

9. Verdampfungskammer nach einem der Ansprüche 1 bis 8, **dadurch gekennzeichnet, dass** die Verdampfungskammer Mittel (16) zum Steuern des Drucks aufweist, um unabhängig den Druck in dem ersten Volumen (25) und dem zweiten Volumen (22) zu messen.

10. Verdampfungskammer nach einem der Ansprüche 1 bis 9, **dadurch gekennzeichnet, dass** die Materialquellen (17), die eine Hauptachse (18) aufweisen, die in dem zweiten Volumen (22) angeordnet sind, Tiegelzellen aufweisen, die durch Joule-Effekt erhitzt werden.

11. Verdampfungskammer nach einem der Ansprüche 1 bis 10, **dadurch gekennzeichnet, dass** die Materialquellen (17), die eine Hauptachse (18) haben, die in dem zweiten Volumen (23) angeordnet sind, Verdampfungskanonen (20) mit Elektronenbeschuss haben.

12. Verdampfungskammer nach einem der Ansprüche 1 bis 11, **dadurch gekennzeichnet, dass** die Quellen (21), die in dem ersten Volumen (25) angeordnet sind, mindestens eine Plasmaquelle aufweisen.

13. Verdampfungskammer nach einem der Ansprüche 1 bis 12, **dadurch gekennzeichnet, dass** die Quellen (21), die in dem ersten Volumen (25) angeordnet sind, mindestens einen Gaseinspritzer aufweisen.
